(19) **Europäisches Patentamt European Patent Office Office européen des brevets**

(11) **EP 1 940 053 B1**

(12) **EUROPEAN PATENT SPECIFICATION**

(45) Date of publication and mention
of the grant of the patent:
**01.08.2012 Bulletin 2012/31**

(51) Int Cl.:
***H04B 17/02*** (2006.01)    ***H03M 1/12*** (2006.01)

(21) Application number: **08150817.8**

(22) Date of filing: **05.06.2003**

(54) **Gain control method and apparatus**

Vorrichtung und Verfahren zur Verstärkungsregelung

Procédé et appareil de contrôle de gain

(84) Designated Contracting States:
**AT BE BG CH CY CZ DE DK EE ES FI FR GB GR HU IE IT LI LU MC NL PT RO SE SI SK TR**

(30) Priority: **11.06.2002 US 388122 P**
**27.12.2002 US 330749**

(43) Date of publication of application:
**02.07.2008 Bulletin 2008/27**

(62) Document number(s) of the earlier application(s) in accordance with Art. 76 EPC:
**03734444.7 / 1 512 237**

(73) Proprietor: **INTERDIGITAL TECHNOLOGY CORPORATION**
**Wilmington, DE 19810 (US)**

(72) Inventors:
• **YANG, Rui**
**Greenlawn, NY 11740 (US)**
• **KAZAKEVICH, Leonid**
**Plainview, NY 11803 (US)**

(74) Representative: **Pierrou, Mattias**
**Awapatent AB**
**P.O. Box 45 086**
**104 30 Stockholm (SE)**

(56) References cited:
**US-A- 4 124 773    US-A- 4 785 463**
**US-A- 4 903 020**

• **PATENT ABSTRACTS OF JAPAN vol. 2000, no. 11, 3 January 2001 (2001-01-03) & JP 2000 236276 A (TOYO COMMUN EQUIP CO LTD), 29 August 2000 (2000-08-29)**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

FIELD OF INVENTION

The present invention relates to the field of wireless communications. More specifically, the present invention relates to an all digital gain control architecture.

BACKGROUND

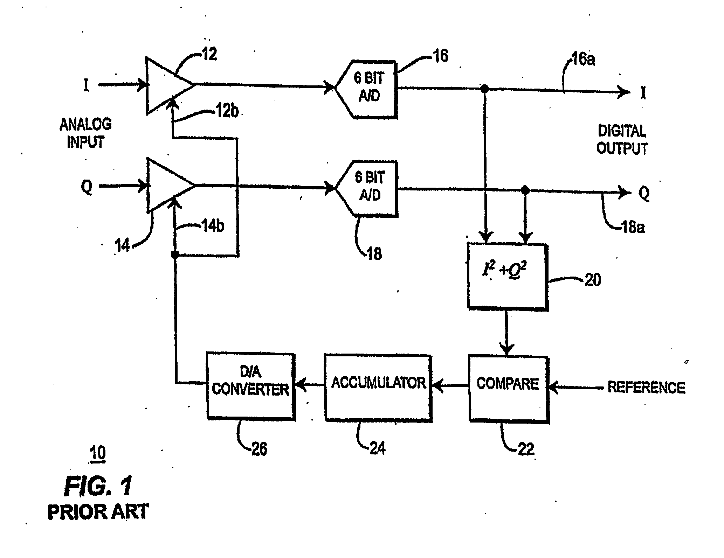

In most wireless communication systems, the baseband signal at a receiver is converted from analog format into digital format so that the useful information can be recovered via a sequence of digital processes. The common device that achieves this conversion is an analog-to-digital converter (ADC). One of the most important specifications of an ADC is the number of output bits. In general, the more output bits the ADC has, the larger the dynamic range of the input signal the ADC can support. However, this results in a more expensive ADC, as well as the rest of the receiver components. Given the number of output bits, if the power of the input signal is too large, the output of the ADC may be saturated. On the other hand, if the power of the input signal is too small, the input signal may be severely quantized. In both of these cases, the information to be recovered at the receiver may be lost. A common approach to solve this problem is to apply a dynamically adjustable gain amplifier in front of the ADC so that the input signal of the ADC can be maintained at a desired level. Typically, the adjustable gain is controlled using a closed-loop mechanism, as shown in Figure 1, which is also called automatic gain control (AGC).

In practice, several requirements need to be considered when using AGC. AGC should be sufficiently fast to compensate for channel loss variation, but should be slow enough so as not to distort the signal envelope. AGC should not change the insertion phase of the radio (so as not to overload the de-rotation loop). AGC should also have a linear response (in dB-per-Volt). AGC is a closed-loop control system, so it has stability, settling time and overshoot concerns as well as other design issues to be considered. AGC is required to have control lines from the modem and often an additional digital-to-analog converter (DAC). In time division duplex (TDD) and Time Division Multiple Access (TDMA) modes, the AGC has to re-adjust the radio gain very fast upon the occurrence of a big unknown step in incoming power. AGC requires a specific radio architecture with gain control, both of which add cost and power consumption. AGC also has design trade offs between NF and IP3 especially in the presence of a big jammer. IP3 is a third order intercept point. NF is a noise figure. The higher the gain before the down-converter (demodulator) the better (lower) the NF, but the IP3 is also lowered (which is not good). In practice, some of the above requirements are difficult to achieve. Certain trade-offs have to be made, resulting in a loss of a certain amount of system level performance.

SUMMARY

The present invention overcomes the problems confronting the techniques presently in use by compressing an input analog signal at baseband and employing a logarithmic technique, converting the compressed signal into digital form and expanding the digital signal to its original linear scale using an antilog technique. Word size of the expanded digital signal may be reduced by a normalization technique.

BRIEF DESCRIPTION OF THE INVENTION

Figure 1 is a block diagram of a prior art closed-loop AGC.

Figure 2 is a block diagram of the all digital gain control (ADGC) using true log amplifiers as compressors and anti-log look-up-table (LUT) as expanders.

Figure 3 is a graph depicting the result of analog compression and digital expansion.

Figure 4 illustrates the improvement of performance for a communication system by a comparison between ADGC and traditional AGC.

DETAILED DESCRIPTION OF THE PREFERRED EMBODIMENTS

Figure 1 shows a prior art closed-loop automatic gain control (AGC) circuit 10 in which analog inputs of I and Q signals are respectively applied to amplifiers 12 and 14. The outputs thereof undergo analog to digital conversion through A/D converters 16, 18 which are shown in the figure as (e.g. 6 bit) A/D converters, providing I and Q outputs at 16a and 18a, respectively.

The outputs of A/D converters 16 and 18 are applied to circuit 20 to obtain a sum of $I^2 + Q^2$ which is then compared to a reference level in comparison circuit 22. The output of comparison circuit 22 is applied to a digital-to-analog converter (DAC) 26 through an accumulator 24 and respectively applied to the gain control inputs 12b, 14b of the gain control amplifiers 12 and 14.

The all digital gain control (ADGC) device 30 of the present invention avoids some of the requirements associated with the nature of the closed-loop AGC circuitry described above, and meets the remaining requirements without too many difficulties. The present invention employs an analog -to- digital conversion method that increases the number of effective ADC bits by compressing the baseband input analog signal using an analog compressor, e.g. logarithmic circuitry. The analog compressor is a nonlinear device where the gain is inversely proportional to the input signal. This increases the dynamic range of the analog input signal.

After the compressed analog signal is converted into a digital signal, a digital expander, e.g. anti-log process or look-up table (LUT), is used to expand the digital signal back to the original linear scale. The digital expander is a nonlinear device where the gain is proportional to the input signal. The word size of the output of the expander may be larger than the input word size due to the nature of the functionality of most expanders. To reduce the word size of the digital signal for the reset of the receiver, a normalization mechanism can be applied, which could be an open loop or closed loop automatic level control block.

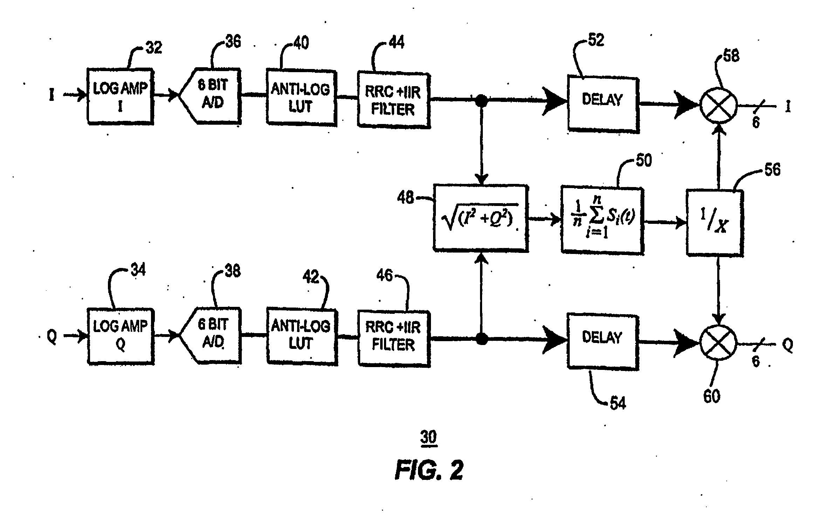

Figure 2 shows a block diagram of the ADGC device 30 of the present invention. The ADGC device employs logarithmic amplifiers 32, 34 for logarithmic amplification of the I and Q signals which are then passed to (e.g. 8 bit) analog -to- digital converters 36, 38 and thereafter passed to anti-log lookup tables (LUTs) 40 and 42 to expand the digital signal and then subsequently passed to a low pass filter (e.g. root-raised cosine infinite impulse response (RRC + IIR) filters 44, 46, each of which are used as an interpolator.

Outputs of filters 44 and 46 are applied to circuitry 48 which determines the square root of the sum of $I^2$ and $Q^2$. The output of circuitry 48 is applied to circuitry 50 which determines the averaged combined power measurements from both the I and Q channels before reducing the number of bits of the digital signal. Circuitry 50 uses Equation 1 to determine the averaged combined power with a block-by-block scheme as follows:

$$\frac{1}{n}\sum_{i=1}^{n} s_i(t) \qquad \text{Equation (1)}$$

where n is the size of the block and $s_i$ is the i-th sample of the output of 50 within the block. The outputs of filters 44 and 46 are delayed by delay circuits 52 and 54 with n samples in order to synchronize the timing between the outputs of the filters 44 and 46 to enable completion of the functions performed by the circuits 48, 50 and 56. As result, the output of 58 and 60 are respectively,

$$\frac{I_k}{\frac{1}{n}\sum_{i=1}^{n} s_i(t)} \quad \text{and} \quad \frac{Q_k}{\frac{1}{n}\sum_{i=1}^{n} s_i(t)} \qquad \text{Equation (2)}$$

where $I_k$ and $Q_k$ for k=1,...,n are n-sample delayed outputs of 44 and 46, respectively.

According to the present invention, an instantaneous dynamic range of 70 dB is easily achievable. An additional 20 to 30 dB can be obtained by switching the LNA on or off. The ADGC device 30 does not require any gain control in the radio, thereby providing benefits of cost and-simplicity. Large instantaneous power variation can be easily supported by the ADGC device 30. The ADGC device 30 also provides good support for high speed down link and packet transmission. Furthermore, since the ADGC device 30 of the present invention is open loop, there are no stability problems, no settling time and no overshoot. ADGC 30 need not have any knowledge about the timing of the signal, which is very important in cell search, code acquisition and frequency correction mode in a system using TDD technology.

The ADGC device 30 provides very fast fading compensation without distorting the signal envelop, which helps avoid the problems encountered with high speeds and/or high data rates, but does not change the insertion phase of the system.

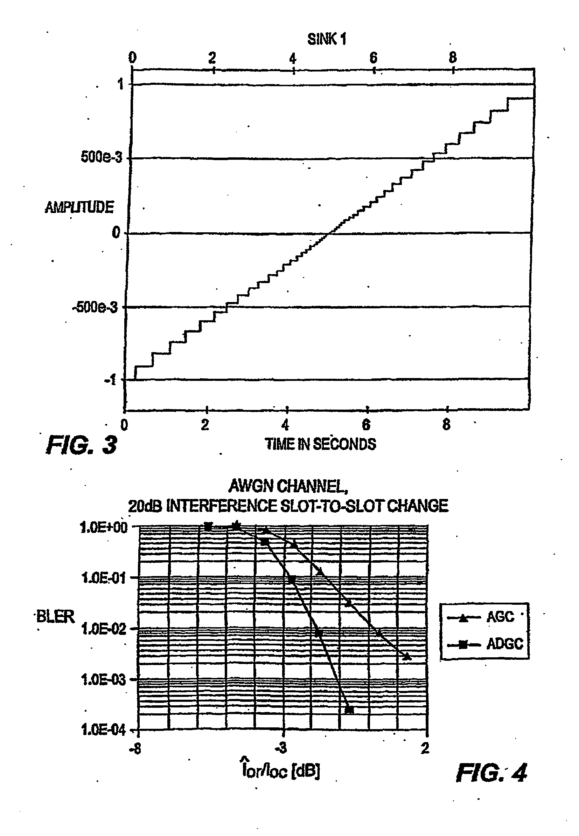

The result of analog compression and digital expansion is shown in Figure 3. In this figure, the stair curve represents the relation of the input of the analog compressor and the output of digital expander. It is clear that, using an analog compression and digital expansion technique, a signal with small magnitude can be quantized with a very small quantization step. This will generate very small quantization noise and, as result, will improve the performance of the receiver.

To observe the improvement of the performance for a communication system, a comparison between the ADGC device 30 of the present invention and a traditional AGC circuit is made using a TDD downlink simulation test bench with ideal multi-user detector and an added white Gaussian noise channel. The simulation result is shown in Figure 4. In this test bench, the input signal undergoes 20dB slot-to-slot power variation. Here we see that ADGC device 30 of the present invention improves the system performance by nearly 2dB at a block error rate (BLER) = 0.01.

ITEMIZED LIST

Item 1. Apparatus for obtaining wide range and high resolution analog-to-digital conversion of an input signal comprising:

an analog compressor to compress the input signal; and

an expander for digitally expanding the compressed signal and which expands the signal back to an original linear scale.

Item 2. The apparatus of item 1 wherein said analog compressor is a logarithmic compressor.

Item 3. The apparatus of item 1 wherein the expander device is an anti-log device.

Item 4. The apparatus of item 3 wherein said expander device includes look-up-table means for determining an anti-log of a compressed signal.

Item 5. The apparatus of item 3 further comprising an analog-to-digital (AD) converter provided between the analog compressor and the digital expander.

Item 6. The apparatus of item 1 further comprising a normalization circuit coupled to said digital expander to reduce word size of the digital output.

Item 7. The apparatus of item 1 wherein said input signal is obtained from a receiver for receiving a wireless communication.

Item 8. The apparatus of item 1 further comprising a receiver for receiving a wireless communication to provide said input signal to said analog compressor.

Item 9. The apparatus of item 1 further comprising a receiver for receiving a wired communication to provide said input signal to said analog compressor.

Item 10. The apparatus of item 1 wherein said input signal is a baseband signal.

Item 11. The apparatus of item 1 wherein a filter is provided to filter an output of the expander.

Item 12. The apparatus of item 11 wherein the filter is a root-raised cosine (RRC) filter.

Item 13. The apparatus of item 11 wherein the filter is an infinite impulse response (IIR) filter.

Item 14. A method employed in a communications system for analog to digital conversion of an input signal, comprising:

a) logarithmically compressing said input signal at baseband; and
b) logarithmically expanding the compressed signal to an original linear scale.

Item 15. The method of item 14 further comprising converting the compressed signal to a digital format prior to the expanding operation.

Item 16. The method of item 14 further comprising normalizing the expanded digital signal.

Item 17. The method of item 14 wherein said input signal is comprised of I and Q components are independently compressed at step (a) and independently expanded at step (b).

Item 18. The method of item 17 wherein said I and Q components are independently converted from analog from to digital form after undergoing step (a) and preparatory to performance of step (b).

Item 19. The method of item 17 where the I and Q signals are filtered and normalized after performance of step (b).

Item 20. The method of item 16 wherein the filtering step includes filtering employing an infinite impulse response (IIR) filter.

Item 21. The method of item 16 wherein the filtering step includes filtering employing a root-raised cosine (RRC) filter.

## Claims

1. A gain controller (30) comprising:

a first low pass filter (44) configured to generate a filtered in-phase, I, signal;

a second low pass filter (46) configured to generate a filtered quadrature, Q, signal;

a normalization circuit (48, 50, 56) coupled to outputs of the first and second low pass filters (44, 46) for adjusting the gain of the filtered I and Q signals on a block-by-block basis as a function of averaged combined signal strength measurements of the filtered I and Q signals;

a first delay circuit (52) electrically coupled to an output of the first low pass filter (44) for outputting a delayed filtered I signal;

a second delay circuit (54) electrically coupled to an output of the second low pass filter (46) for outputting a delayed filtered Q signal;

a first multiplier (58) having a first input electrically coupled to an output of the first delay circuit (52), and a second input electrically coupled to an output of the normalization circuit (48, 50, 56) used to adjust the gain of the delayed filtered I signal, wherein the first multiplier (58) outputs a value substantially equal to the delayed filtered I signal divided by the averaged combined signal strength of the filtered I and Q signals; and

a second multiplier (60) having a first input electrically coupled to an output of the second delay circuit (54), and a second input electrically coupled to an output of the normalization circuit (48, 50, 56) used to adjust the gain of the delayed filtered Q signal, wherein the second multiplier (60) outputs a value substantially equal to the delayed filtered Q signal divided by the averaged combined signal strength of the filtered I and Q signals.

2. The gain controller (30) of claim 1 further comprising:

a first analog compressor (32) for compressing a received I signal into a compressed analog I signal;
a first analog-to-digital, A/D, converter (36) electrically coupled to an output of the first analog compressor (32) for converting the compressed analog I signal into a compressed digital I signal;
a first expander (40) electrically coupled to an output of the first A/D converter (36) and an input of the first low pass filter (44), the first expander (40) configured to expand the compressed digital I signal back to an original linear scale;
a second analog compressor (34) for compressing a received Q signal into a compressed analog Q signal;
a second A/D converter (38) electrically coupled to an output of the second analog compressor (34) for converting the compressed analog Q signal into a compressed digital Q signal; and
a second expander (42) electrically coupled to an output of the second A/D converter (38) and an input of the second low pass filter (46), the second expander (32) configured to expand the compressed digital Q signal back to an original linear scale.

3. The gain controller (30) of claim 2 wherein the first and second compressors (32, 34) are logarithmic amplifiers.

4. The gain controller (30) of claim 2 wherein the first and second expanders (40, 42) are anti-log look-up tables, LUTs.

5. The gain controller (30) of claim 1 wherein the normalization circuit (48, 50, 56) reduces word size of the filtered I and Q signals.

6. The gain controller (30) of claim 1 wherein each of the first and second low pass filters (44, 46) is a root-raised cosine, RRC, filter.

7. The gain controller (30) of claim 1 wherein each of the first and second low pass filters (44, 46) is an infinite impulse response, IIR, filter.

8. A gain control method for obtaining wide range and high resolution analog-to-digital conversion of an in-phase, I, signal and a quadrature, Q, signal, the method comprising:

filtering a digital I signal to generate a filtered I signal;
filtering a digital Q signal to generate a filtered Q signal;
adjusting the gain of the filtered I and Q signals on a block-by-block basis as a function of averaged combined power measurements of the filtered I and Q signals;
delaying the filtered I signal to generate a delayed filtered I signal;
delaying the filtered Q signal to generate a delayed filtered Q signal;
dividing the delayed filtered I signal by the averaged combined signal strength of the filtered I and Q signals; and
dividing the delayed filtered Q signal by the averaged combined signal strength of the filtered I and Q signals.

9. The method of claim 8 further comprising:

compressing a received I signal into a compressed analog I signal;
converting the compressed analog I signal into a compressed digital I signal;
expanding the compressed digital I signal back to an original linear scale;
compressing a received Q signal into a compressed analog Q signal;
converting the compressed analog Q signal into a compressed digital Q signal; and
expanding the compressed digital Q signal back to an original linear scale.

10. The method of claim 9 wherein the received I signal is logarithmically compressed into the compressed analog I signal at baseband.

11. The method of claim 9 wherein the received Q signal is logarithmically compressed into the compressed analog Q signal at baseband.

**12.** The method of claim 9 wherein the compressed digital I signal is logarithmically expanded.

**13.** The method of claim 9 wherein the compressed digital Q signal is logarithmically expanded.

**Patentansprüche**

**1.** Verstärkungsregler (30), umfassend:

ein erstes Tiefpassfilter (44), welches gestaltet ist zum Erzeugen eines gefilterten Inphase-Signals, I-Signals;
ein zweites Tiefpassfilter (46), welches gestaltet ist zum Erzeugen eines gefilterten Quadratursignals, Q-Signals;
eine Normierungsschaltung (48, 50, 56), welche gekoppelt ist mit einem Ausgang des ersten und des zweiten Tiefpassfilters (44, 46),
zum Anpassen der Verstärkung des gefilterten 1- und Q-Signals, auf einer Block-für-Block-Basis, als eine Funktion gemittelter,
zusammengerechneter Signalstärkemessungen des gefilterten 1- und
Q-Signals;
eine erste Verzögerungsschaltung (52), welche elektrisch gekoppelt ist mit einem Ausgang des ersten Tiefpassfilters (44), zum Ausgeben eines verzögerten, gefilterten I-Signals;
eine zweite Verzögerungsschaltung (54), welche elektrisch gekoppelt ist mit einem Ausgang des zweiten Tiefpassfilters (46), zum Ausgeben eines verzögerten, gefilterten Q-Signals;
einen ersten Multiplizierer (58), welcher einen ersten Eingang aufweist,
der elektrisch gekoppelt ist mit einem Ausgang der ersten Verzögerungsschaltung (52), und einen zweiten Eingang, der elektrisch gekoppelt ist mit einem Ausgang der Normierungsschaltung (48, 50, 56), die verwendet wird, um die Verstärkung des verzögerten, gefilterten I-Signals anzupassen, wobei der erste Multiplizierer (58) einen Wert ausgibt, der im Wesentlichen gleich ist dem verzögerten, gefilterten I-Signal, geteilt durch die gemittelte, zusammengerechnete Signalstärke des gefilterten 1- und Q-Signals; und
einen zweiten Multiplizierer (60), welcher einen ersten Eingang aufweist, der elektrisch gekoppelt ist mit einem Ausgang der zweiten Verzögerungsschaltung (54), und einen zweiten Eingang, der elektrisch gekoppelt ist mit einem Ausgang der Normierungsschaltung (48, 50, 56), die verwendet wird, um die Verstärkung des verzögerten, gefilterten Q-Signals anzupassen, wobei der zweite Multiplizierer (60) einen Wert ausgibt, der im Wesentlichen gleich ist dem verzögerten,
gefilterten Q-Signal, geteilt durch die gemittelte, zusammengerechnete Signalstärke des gefilterten 1- und Q-Signals.

**2.** Verstärkungsregler (30) nach Anspruch 1, ferner umfassend:

einen ersten Analog-Signalkompressor (32) zum Komprimieren eines empfangenen 1-Signals zu einem komprimierten analogen I-Signal;
einen ersten Analog/Digital-Wandler, A/D-Wandler (36), welcher elektrisch gekoppelt ist mit einem Ausgang des ersten Analog-Signalkompressors (32), zum Umwandeln des komprimierten analogen 1-Signals in ein komprimiertes digitales I-Signal;
einen ersten Signal-Expander (40), welcher elektrisch gekoppelt ist mit einem Ausgang des ersten A/D-Wandlers (36) und einem Eingang des ersten Tiefpassfilters (44), wobei der erste Signal-Expander (40) gestaltet ist zum Dekomprimieren des komprimierten digitalen 1-Signals, zurück in einen ursprünglichen linearen Bereich;
einen zweiten Analog-Signalkompressor (34) zum Komprimieren eines empfangenen Q-Signals zu einem komprimierten analogen Q-Signal;
einen zweiten A/D-Wandler (38), welcher elektrisch gekoppelt ist mit einem Ausgang des zweiten Analog-Signalkompressors (34), zum Umwandeln des komprimierten analogen Q-Signals in ein komprimiertes digitales Q-Signal; und
einen zweiten Signal-Expander (42), welcher elektrisch gekoppelt ist mit einem Ausgang des zweiten A/D-Wandlers (38) und einem Eingang des zweiten Tiefpassfilters (46), wobei der zweite Signal-Expander (32) gestaltet ist zum Dekomprimieren des komprimierten digitalen Q-Signals, zurück in einen ursprünglichen linearen Bereich.

**3.** Verstärkungsregler (30) nach Anspruch 2, wobei der erste und der zweite Signal-Kompressor (32, 34) logarithmische Verstärker sind.

**4.** Verstärkungsregler (30) nach Anspruch 2, wobei der erste und der zweite Signal-Expander (40, 42) umgekehrt logarithmische Nachschlagetabellen, LUTs, sind.

**5.** Verstärkungsregler (30) nach Anspruch 1, wobei die Normierungsschaltung (48, 50, 56) die Wortlänge des gefilterten 1- und Q-Signals verringert.

**6.** Verstärkungsregler (30) nach Anspruch 1, wobei ein jedes von dem ersten und dem zweiten Tiefpassfilter (44, 46) ein Wurzel-Kosinus-Filter, RRC-Filter ist.

**7.** Verstärkungsregler (30) nach Anspruch 1, wobei ein jedes von dem ersten und dem zweiten Tiefpassfilter (44, 46) ein Filter mit unendlicher Impulsantwort, IIR-Filter, ist.

**8.** Verstärkungsregelungs-Verfahren zum Herbeiführen einer Analog-Digital-Umwandlung, in einem weiten Bereich und mit hoher Auflösung, eines Inphase-Signals, I-Signals und eines Quadratursignals, Q-Signals, wobei das Verfahren umfasst:

Filtern eines digitalen I-Signals, um ein gefiltertes I-Signal zu erzeugen;
Filtern eines digitalen Q-Signals, um ein gefiltertes Q-Signal zu erzeugen;
Anpassen der Verstärkung des gefilterten I- und Q-Signals auf einer Block-für-Block-Basis, als eine Funktion gemittelter,
zusammengerechneter Signalstärkemessungen an dem gefilterten I-und Q-Signal;
Verzögern des gefilterten I-Signals, um ein verzögertes gefiltertes 1-Signal zu erzeugen;
Verzögern des gefilterten Q-Signals, um ein verzögertes gefiltertes Q-Signal zu erzeugen;
Teilen des verzögerten gefilterten I-Signals durch die gemittelte,
zusammengerechnete Signalstärke des gefilterten 1- und Q-Signals;
und
Teilen des verzögerten gefilterten Q-Signals durch die gemittelte,
zusammengerechnete Signalstärke des gefilterten 1- und Q-Signals.

**9.** Verfahren nach Anspruch 8, ferner umfassend:

Komprimieren eines empfangenen I-Signals zu einem komprimierten analogen I-Signal;
Umwandeln des komprimierten analogen I-Signals in ein komprimiertes digitales I-Signal;
Dekomprimieren des komprimierten digitalen I-Signals, zurück in einen ursprünglichen linearen Bereich;
Komprimieren eines empfangenen Q-Signals zu einem komprimierten analogen Q-Signal;
Umwandeln des komprimierten analogen Q-Signals in ein komprimiertes digitales Q-Signal; und
Dekomprimieren des komprimierten digitalen Q-Signals, zurück in einen ursprünglichen linearen Bereich.

**10.** Verfahren nach Anspruch 9, wobei das empfangene I-Signal logarithmisch komprimiert wird zu dem komprimierten analogen 1-Signal, im Basisband.

**11.** Verfahren nach Anspruch 9, wobei das empfangene Q-Signal logarithmisch komprimiert wird zu dem komprimierten analogen Q-Signal, im Basisband.

**12.** Verfahren nach Anspruch 9, wobei das komprimierte digitale 1-Signal logarithmisch dekomprimiert wird.

**13.** Verfahren nach Anspruch 9, wobei das komprimierte digitale Q-Signal logarithmisch dekomprimiert wird.

**Revendications**

**1.** Dispositif de commande de gain (30) comprenant :

un premier filtre passe-bas (44) configuré pour générer un signal en phase, I, filtré
un deuxième filtre passe-bas (46) configuré pour générer un signal en quadrature, Q, filtré ;
un circuit de normalisation (48, 50, 56) couplé aux sorties des premier et deuxième filtres passe-bas (44, 46) pour ajuster le gain des signaux I et Q filtrés sur une base bloc par bloc en fonction de mesures de force de signal combinée moyennée des signaux I et Q filtrés ,

un premier circuit de délai (52) couplé électriquement à une sortie du premier filtre passe-bas (44) pour délivrer un signal I filtré retardé ;

un deuxième circuit de délai (54) couplé électriquement à une sortie du deuxième filtre passe-bas (46) pour délivrer un signal Q filtré retardé ;

un premier multiplicateur (58) ayant une première entrée couplée électriquement à une sortie du premier circuit de délai (52), et une deuxième entrée couplée électriquement à une sortie du circuit de normalisation (48, 50, 56) utilisée pour ajuster le gain du signal I filtré retardé, dans lequel le premier multiplicateur (58) délivre une valeur sensiblement égale au signal I filtré retardé divisé par la force de signal combinée moyennée des signaux I et Q filtrés ; et

un deuxième multiplicateur (60) ayant une première entrée couplée électriquement à une sortie du deuxième circuit de délai (54), et une deuxième entrée couplée électriquement à une sortie du circuit de normalisation (48, 50, 56) utilisée pour ajuster le gain du signal Q filtré retardé, dans lequel le deuxième multiplicateur (60) délivre une valeur sensiblement égale au signal Q filtré retardé divisé par la force de signal combinée moyennée des signaux I et Q filtrés.

2. Dispositif de commande de gain (30) selon la revendication 1, comprenant en outre :

un premier compresseur analogique (32) pour compresser un signal I reçu en un signal I analogique compressé ;

un premier convertisseur analogique-numérique, A/D, (36) couplé électriquement à une sortie du premier compresseur analogique (32) pour convertir le signal I analogique compressé en un signal I numérique compressé ;

un premier extenseur (40) couplé électriquement à une sortie du premier convertisseur A/D (36) et une entrée du premier filtre passe-bas (44), le premier extenseur (40) étant configuré pour étendre le signal I numérique compressé à une échelle linéaire d'origine ;

un deuxième compresseur analogique (34) pour compresser un signal Q reçu en un signal Q analogique compressé ;

un premier convertisseur A/D (38) couplé électriquement à une sortie du deuxième compresseur analogique (34) pour convertir le signal Q analogique compressé en un signal Q numérique compressé ; et

un deuxième extenseur (42) couplé électriquement à une sortie du deuxième convertisseur A/D (38) et une entrée du deuxième filtre passe-bas (46), le deuxième extenseur (32) étant configuré pour étendre le signal Q numérique compressé à une échelle linéaire d'origine.

3. Dispositif de commande de gain (30) selon la revendication 2, dans lequel les premier et deuxième compresseurs (32, 34) sont des amplificateurs logarithmiques.

4. Dispositif de commande de gain (30) selon la revendication 2, dans lequel les premier et deuxième extenseurs (40, 42) sont des tables de recherche, LUT, d'anti-logarithmes.

5. Dispositif de commande de gain (30) selon la revendication 1, dans lequel le circuit de normalisation (48, 50, 56) réduit la taille de mot des signaux I et Q filtrés.

6. Dispositif de commande de gain (30) selon la revendication 1, dans lequel chacun des premier et deuxième filtres passe-bas (44, 46) est un filtre en racine de cosinus surélevé, RRC.

7. Dispositif de commande de gain (30) selon la revendication 1, dans lequel chacun des premier et deuxième filtres passe-bas (44, 46) est un filtre à réponse d'impulsion infinie, IIR.

8. Procédé de commande de gain pour obtenir une conversion analogique-numérique de large plage et de haute résolution d'un signal en phase, I, et d'un signal en quadrature, Q, le procédé comprenant :

le filtrage d'un signal I numérique pour générer un signal I filtré ;

le filtrage d'un signal Q numérique pour générer un signal Q filtré ,

l'ajustement du gain des signaux I et Q filtrés sur une base bloc par bloc en fonction de mesures de puissance combinée moyennée des signaux I et Q filtrés ,

le retard du signal I filtré pour générer un signal I filtré retardé ;

le retard du signal Q filtré pour générer un signal Q filtré retardé ;

la division du signal I filtré retardé par la force de signal combinée moyennée des signaux I et Q filtrés  et

la division du signal Q filtré retardé par la force de signal combinée moyennée des signaux I et Q filtrés.

9. Procédé selon la revendication 8, comprenant en outre :

la compression d'un signal I reçu en un signal I analogique compressé ;
la conversion du signal I analogique compressé en un signal I numérique compressé ;
l'extension du signal I numérique compressé à une échelle linéaire d'origine ;
la compression d'un signal Q reçu en un signal Q analogique compressé ;
la conversion du signal Q analogique compressé en un signal Q numérique compressé ; et
l'extension du signal Q numérique compressé à une échelle linéaire d'origine.

10. Procédé selon la revendication 9, dans lequel le signal I reçu est compressé par compression logarithmique en signal I analogique compressé à bande de base.

11. Procédé selon la revendication 9, dans lequel le signal Q reçu est compressé par compression logarithmique en signal Q analogique compressé à bande de base.

12. Procédé selon la revendication 9, dans lequel le signal I numérique compressé est étendu par extension logarithmique.

13. Procédé selon la revendication 9, dans lequel le signal Q numérique compressé est étendu par extension logarithmique.

*FIG. 1*
PRIOR ART

$\underline{30}$

*FIG. 2*

EP 1 940 053 B1

SINK 1

**FIG. 3**

TIME IN SECONDS

AWGN CHANNEL,
20dB INTERFERENCE SLOT-TO-SLOT CHANGE

**FIG. 4**